# EUROPEAN PATENT APPLICATION

(11) **EP 4 819 112 A1**
(43) Date of publication of application: **07.10.2026**
(21) Application number: 24895352.3
(22) Date of filing: 21.03.2024
(51) Int. Cl.: G09F 9/33

(54) **TRANSPARENT LIGHT-EMITTING MODULE AND TRANSPARENT DISPLAY SCREEN**

(30) Priority: 01.12.2023 CN 202323308207 U
(71) Applicant: Lin, Jianhan, Shenzhen, Guangdong 518000 (CN)
(72) Inventor: Lin, Jianhan, Shenzhen, Guangdong 518000 (CN)
(74) Representative: Herrero & Asociados, S.L.
(86) International application number: PCT/CN2024/082894
(87) International publication number: WO 2025/112239

(57) **Abstract**

A transparent light-emitting module (100) and a transparent display screen (1000) are provided. The transparent light-emitting module (100) includes a light-transmitting substrate (1) and a light-transmitting cover plate (2). Light-transmitting holes are correspondingly arranged in arrays on both the light-transmitting substrate (1) and the light-transmitting cover plate (2); areas excluding the light-transmitting holes form a non-light-transmitting area. The light-transmitting hole on the light-transmitting substrate (1) is a first light-transmitting hole (11), and the light-transmitting hole on the light-transmitting cover plate (2) is a second light-transmitting holes (21). The light-transmitting substrate (1) is provided with a driver circuit and pixel pads, and the pixel pads are arranged in an array within the non-light-transmitting area excluding the first light-transmitting holes (11). A plurality of light-emitting pixels (12) are mounted on the pixel pads and are connected to the driver circuit through the pixel pads. Each light-emitting pixel (12) includes a driver chip (121) and a light-emitting die. Pixel through holes (22) are arranged in an array within the non-light-transmitting area excluding the second light-transmitting holes (21) on the light-transmitting cover plate (2), and the pixel through holes (22) correspond to the pixel pads, allowing the light-emitting pixels (12) to be located within the pixel through holes (22). The transparent display screen (1000) includes a light-transmitting motherboard (3) and one or more transparent light-emitting modules (100) mounted on the light-transmitting motherboard (3). The light-transmitting motherboard (3) is provided with a light-transmitting area and a non-light-transmitting area. The non-light-transmitting area is provided with a transmission circuit configured to supply power and signals to the transparent light-emitting module (100). Each transparent light-emitting module (100) is electrically connected to the light-transmitting motherboard (3).

## Description

This application claims priority to Chinese Patent Application No. 202323308207.9, filed on December 1, 2023, titled "Transparent Light-Emitting Module and Transparent Display Screen", the contents of which are incorporated herein by reference in their entirety.

### Technical Field

The present application relates to the field of transparent display screens, and more particularly to the field of transparent display screens in which light-transmitting holes are provided in circuit boards.

### Background

Transparent LED display screens have been increasingly used in the market, evolving into various product forms. One approach uses a PCB board, where rows or columns are cut to form transparent areas and non-light-transmitting areas. LED beads are arranged in arrays on the non-light-transmitting areas to achieve a semi-transparent light-emitting display effect. As an improvement, the applicant previously proposed an optimized solution in which strip-shaped PCB boards are pre-fabricated, LED strips are mounted on the sides of the PCB boards, and the strips are installed at intervals to achieve a similar semi-transparent effect. However, both solutions offer relatively poor transparency performance.

As a further improvement, a transparent LED display screen technology has emerged, in which LED lamp beads are distributed in an array on a transparent glass panel. The inventor recognized that this type of transparent display screen offers the best transparency and light transmittance performance. However, forming circuits on a glass panel is technically challenging, involves complex manufacturing processes, and results in high costs.

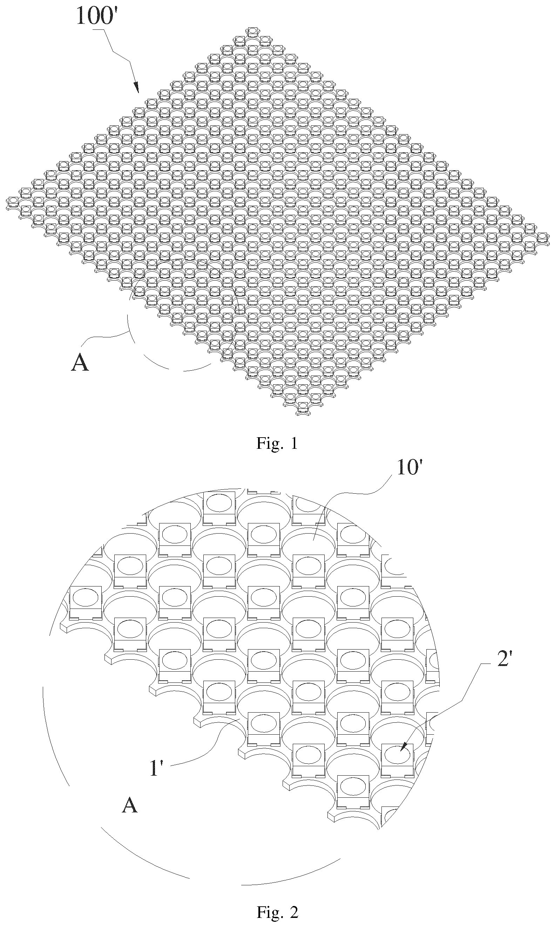

As an alternative, a transparent display screen 100' is disclosed in the art, as shown in Figs. 1 to 6. It includes a circuit substrate 1', which has multiple through holes 10' passing through both its front and back sides to form a light-transmitting ares and non-light-transmitting area on the circuit substrate 1'. The non-light-transmitting area on the front side is arranged with an array of mounting pads for LED lamp bead 2', with LED lamp beads 2' mounted protruding on the mounting pads on the front of the circuit substrate 1'. These LED lamp beads 2' typically include a driver chip and a light-emitting die. Therefore, the internal circuit of the circuit substrate 1' is relatively simple, and in most cases, no additional electronic components need to be installed, resulting in a thin and tidy screen. This type of direct installation of the LED lamp bead 2' onto the circuit substrate 1', which is arranged with evenly distributed through holes 10', achieves both display functionality and a transparent effect.

The inventor realized that this transparent display screen 100' also has significant drawbacks. In many application scenarios, as shown in Figs. 1 to 4, when installed on a transparent glass 3', the LED lamp bead 2' protrudes from the circuit substrate 1', making it prone to collisions, which can cause damage or detachment, and preventing it from adhering smoothly to the surface of the transparent glass 3'. Additionally, the pins of the LED lamp bead 2' that are soldered to the circuit substrate 1' are fully exposed to the air, making the LED lamp bead 2' vulnerable to damage from static electricity and humidity in the air. Furthermore, as shown in Figs. 5 and 6, due to the size limitations of the LED lamp bead 2', the resolution and transparency of the transparent display screen 100' still need to be improved.

### Summary of the Invention

To address the issues in the prior art, such as the LED lamp beads of the transparent display screen being easily damaged, difficult to adhere smoothly and flatly during installation, and the need for further improvements in resolution and transparency, the present application provides a transparent light-emitting module and a transparent display screen.

In one aspect, the embodiment of the present application provides a transparent light-emitting module, including a light-transmitting substrate and a light-transmitting cover plate; wherein:
light-transmitting holes are correspondingly arranged in arrays on both the light-transmitting substrate and the light-transmitting cover plate; areas excluding the light-transmitting holes form a non-light-transmitting area;
the light-transmitting hole on the light-transmitting substrate is a first light-transmitting hole, and the light-transmitting hole on the light-transmitting cover plate is a second light-transmitting hole;
the light-transmitting substrate is provided with a driver circuit and pixel pads, and the pixel pads are arranged in an array within the non-light-transmitting area excluding the first light-transmitting holes; a plurality of light-emitting pixels are mounted on the pixel pads and are connected to the driver circuit through the pixel pads; each light-emitting pixel includes a driver chip and a light-emitting die; and
pixel through holes are arranged in an array within the non-light-transmitting area excluding the second light-transmitting holes on the light-transmitting cover plate; and the pixel through holes correspond to the pixel pads, allowing the light-emitting pixels to be located within the pixel through holes.

This application, through the aforementioned method, arranges the light-emitting pixels within the pixel through holes arranged on the light-transmitting cover plate, preventing the light-emitting pixels from being easily damaged by impact. It allows the light-emitting pixels to not have exposed solder joints, making it easier to achieve water and moisture resistance. The light-emitting display surface of the transparent light-emitting module is the light-transmitting cover plate, which provides a flat, smooth display surface that can be directly adhered to flat products such as glass. Furthermore, compared to existing technologies, under the same spacing conditions, the light-emitting pixels occupy less area, thereby increasing the display density and improving the resolution of the transparent display screen.

In another aspect, the embodiment of the present application provides a transparent display screen, including a light-transmitting motherboard and one or more transparent light-emitting modules mounted on the light-transmitting motherboard; wherein:
the light-transmitting motherboard is provided with a light-transmitting area and a non-light-transmitting area; the non-light-transmitting area is provided with a transmission circuit configured to supply power and signals to the transparent light-emitting module; each transparent light-emitting module is electrically connected to the light-transmitting motherboard;
each transparent light-emitting module includes a light-transmitting substrate and a light-transmitting cover plate; light-transmitting holes are correspondingly arranged in arrays on both the light-transmitting substrate and the light-transmitting cover plate, and projections of the light-transmitting holes fall within the light-transmitting area of the light-transmitting motherboard; and areas excluding the light-transmitting holes form a non-light-transmitting area;
the light-transmitting hole on the light-transmitting substrate is a first light-transmitting hole, and the light-transmitting hole on the light-transmitting cover plate is a second light-transmitting hole;
the light-transmitting substrate is provided with a driver circuit and pixel pads, and the pixel pads are arranged in an array within the non-light-transmitting area excluding the first light-transmitting holes; a plurality of light-emitting pixels are mounted on the pixel pads and are connected to the driver circuit through the pixel pads; each light-emitting pixel includes a driver chip and a light-emitting die; and
pixel through holes are arranged in an array within the non-light-transmitting area excluding the second light-transmitting holes on the light-transmitting cover plate; and the pixel through holes correspond to the pixel pads, allowing the light-emitting pixels to be located within the pixel through holes.

The transparent display screen provided in this example allows the light-emitting pixels to be arranged within the pixel through holes on the light-transmitting cover plate, preventing the light-emitting pixels from being easily damaged by impact. It allows the light-emitting pixels to not have exposed solder joints, making it easier to achieve water and moisture resistance. The light-emitting display surface of the transparent light-emitting module is the light-transmitting cover plate, which provides a flat, smooth display surface that can be directly adhered to flat products such as glass. Furthermore, compared to existing technologies, under the same spacing conditions, the light-emitting pixels occupy less area, thereby increasing the display density and improving the resolution of the transparent display screen.

The details of one or more embodiments of the present application are presented in the following drawings and description. Other features and advantages of the present application will become apparent from the specification, drawings, and claims.

### Brief description of the Drawing

Fig. 1 is a perspective schematic diagram of the transparent display screen provided in the prior art.
Fig. 2 is an enlarged schematic diagram of area A in Fig. 1.

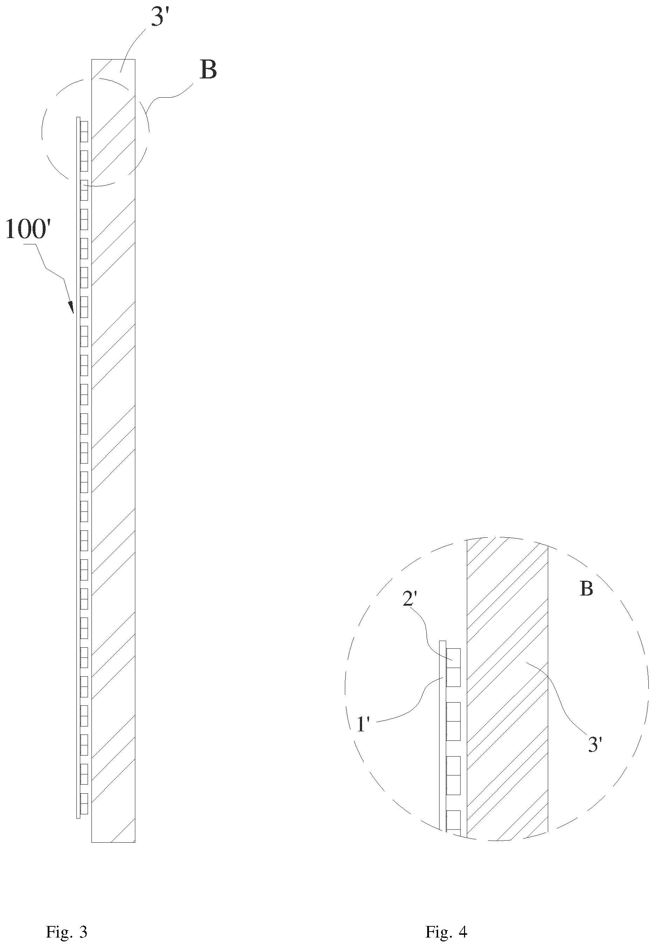

Fig. 3 is a cross-sectional schematic diagram of the transparent display screen provided in the prior art.
Fig. 4 is an enlarged schematic diagram of area B in Fig. 3.

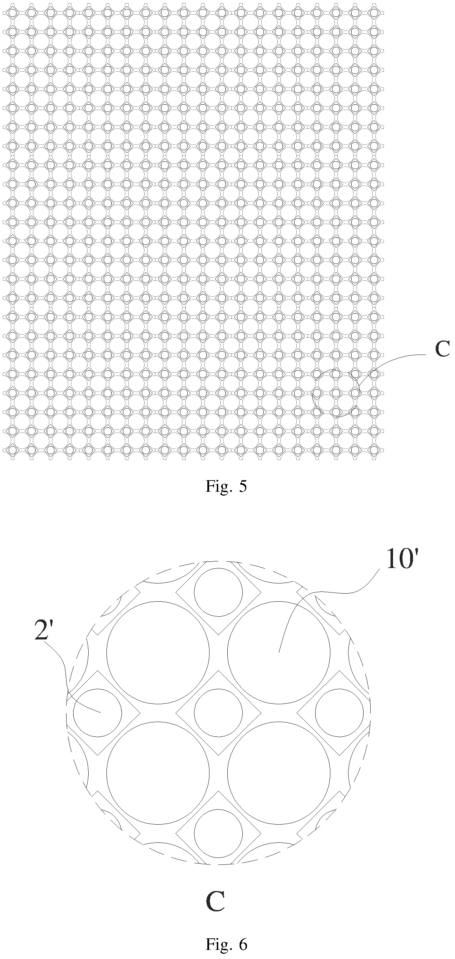

Fig. 5 is a front view schematic diagram of the transparent display screen provided in the prior art.
Fig. 6 is an enlarged schematic diagram of area C in Fig. 5.

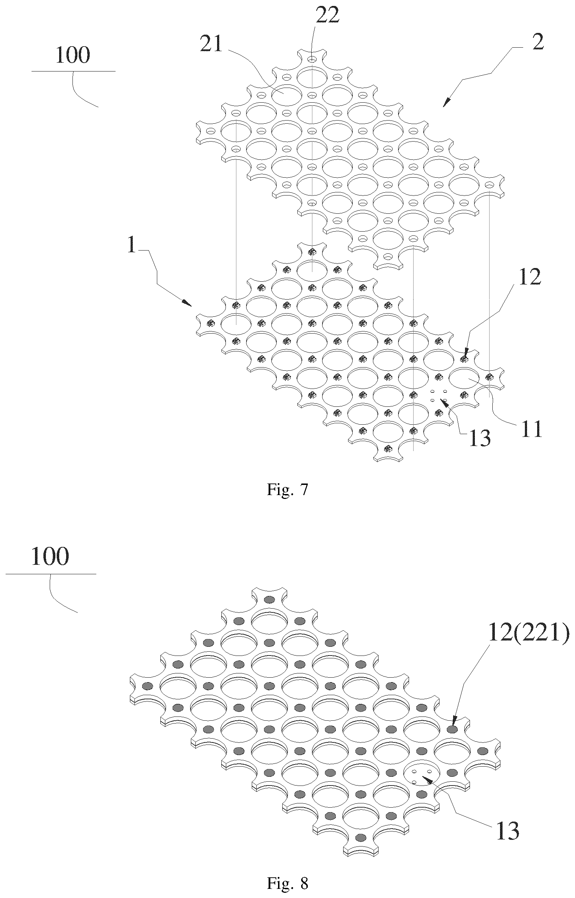

Fig. 7 is an exploded perspective schematic diagram of the transparent light-emitting module provided in a specific embodiment of the present application.
Fig. 8 is a perspective schematic diagram of the transparent light-emitting module provided in a specific embodiment of the present application.

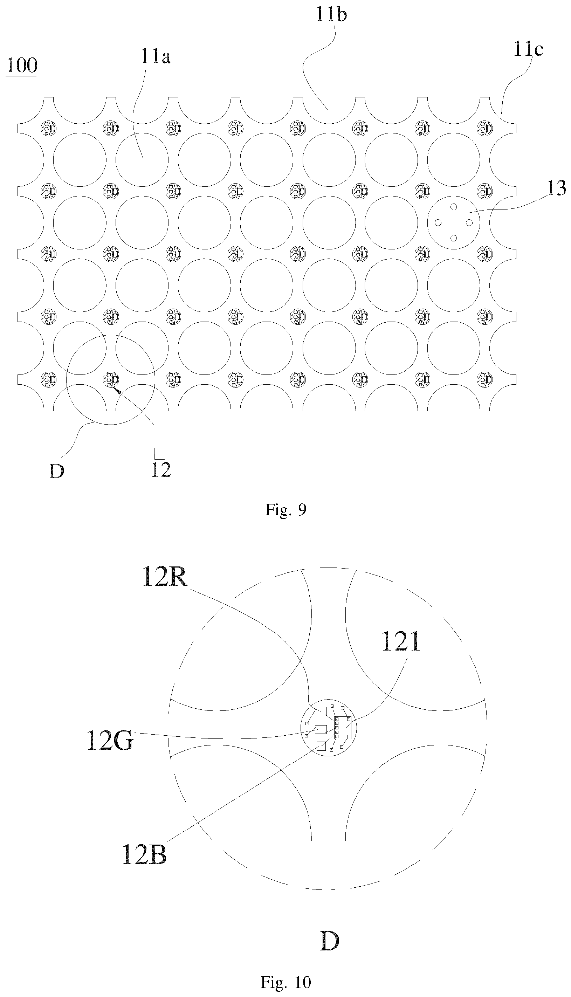

Fig. 9 is a top view schematic diagram of the transparent light-emitting module provided in a specific embodiment of the present application.
Fig. 10 is a schematic diagram of the light-emitting pixel in the enlarged view of area D in Fig. 9.

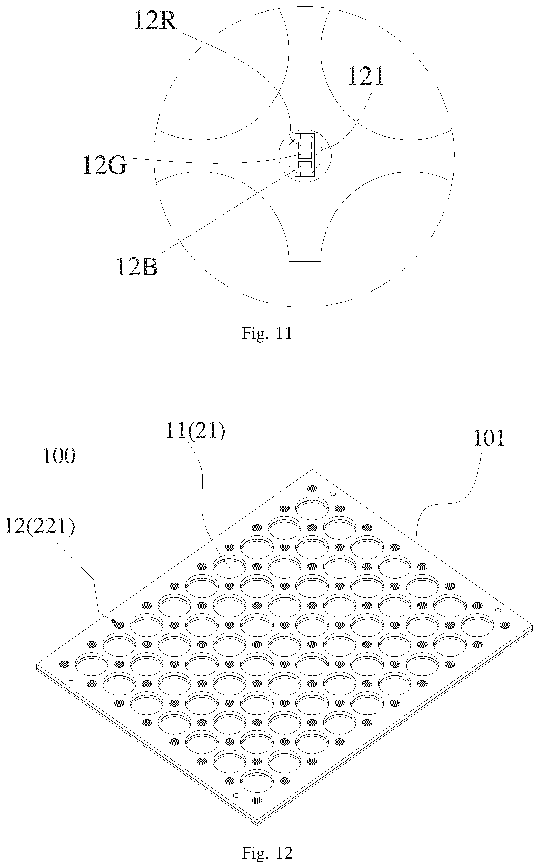

Fig. 11 is another schematic diagram of the light-emitting pixel in the enlarged view of area D in Fig. 9.
Fig. 12 is perspective schematic diagram of another transparent light-emitting module provided in a specific embodiment of the present application.

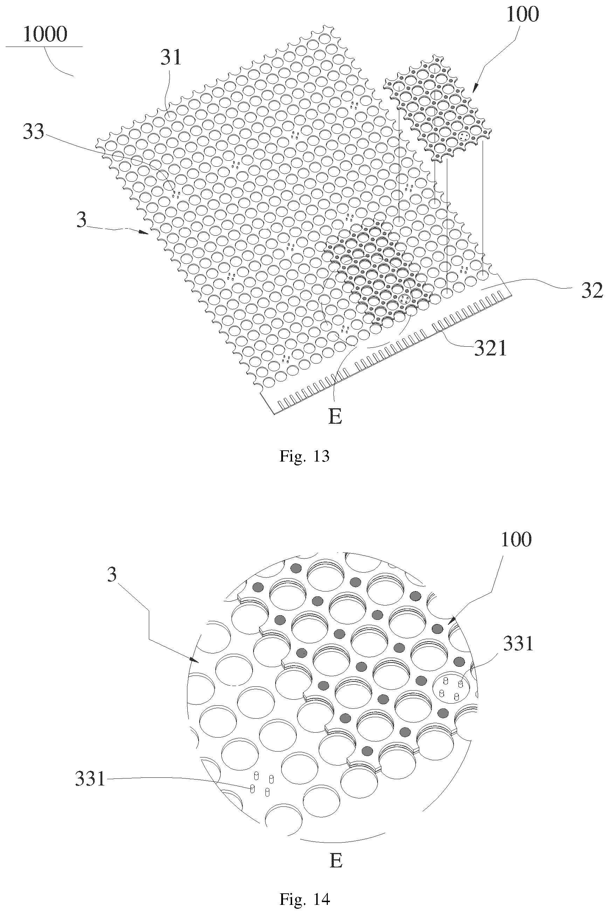

Fig. 13 is an exploded perspective schematic diagram of the transparent display screen provided in a specific embodiment of the present application.
Fig. 14 is an enlarged view of area E in Fig. 13.

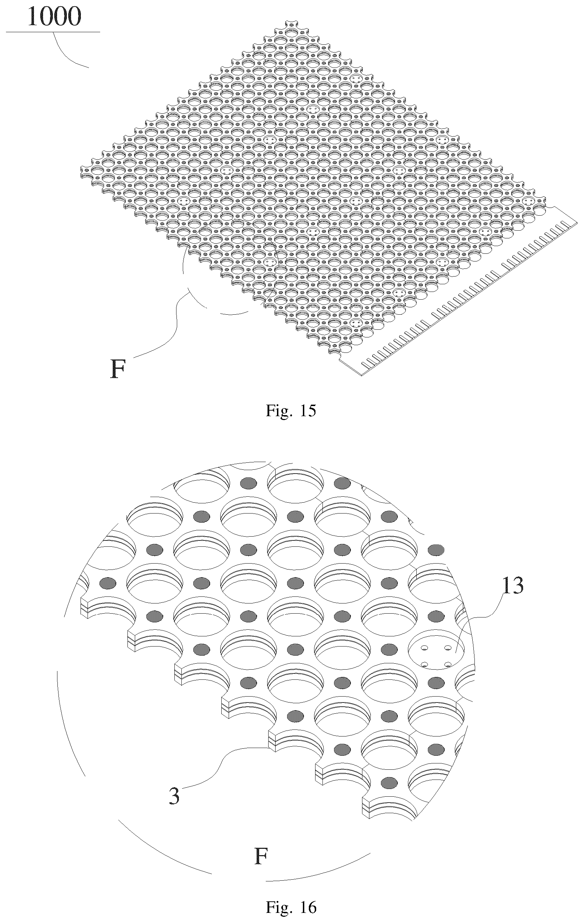

Fig. 15 is a 3D diagram of the transparent display screen provided in a specific embodiment of the present application.
Fig. 16 is an enlarged view of area F in Fig. 15.

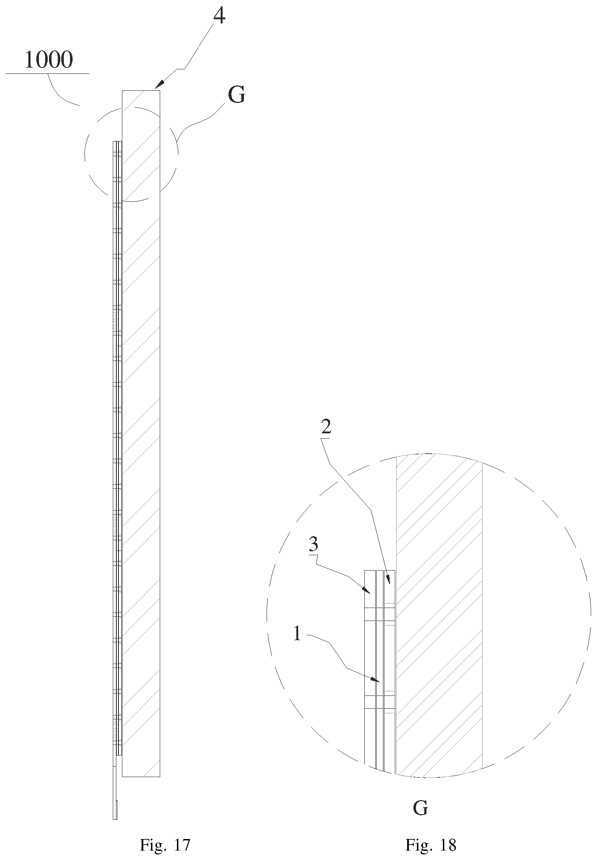

Fig. 17 is a cross-sectional diagram of the transparent display screen provided in a specific embodiment of the present application.
Fig. 18 is an enlarged view of area G in Fig. 17.

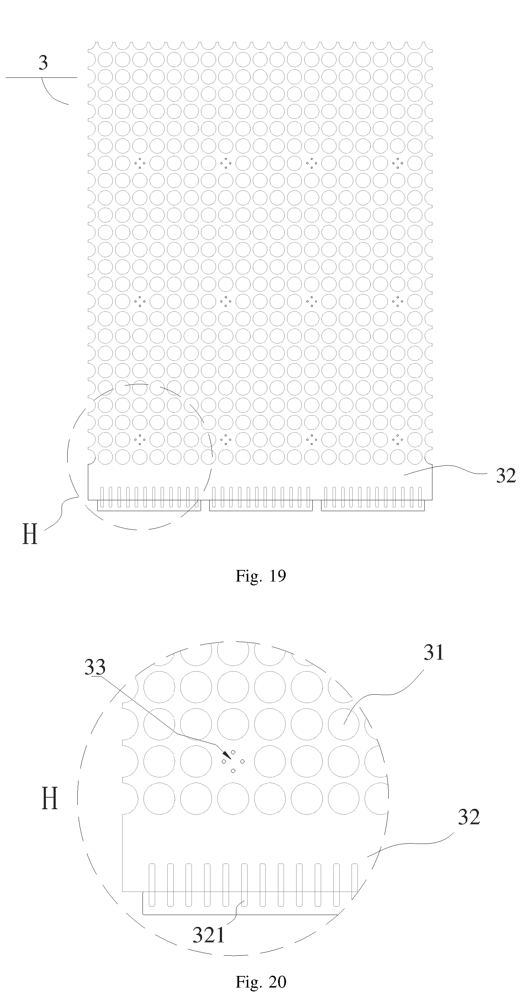

Fig. 19 is a front view diagram of the light-transmitting motherboard provided in a specific embodiment of the present application.
Fig. 20 is an enlarged view of area H in Fig. 19.

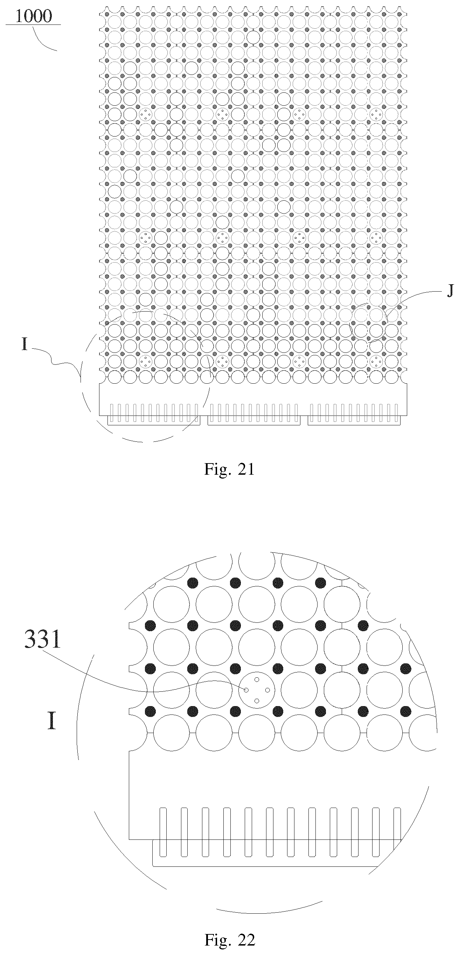

Fig. 21 is a front view diagram of the transparent display screen provided in a specific embodiment of the present application.
Fig. 22 is an enlarged view of area I in Fig. 21.

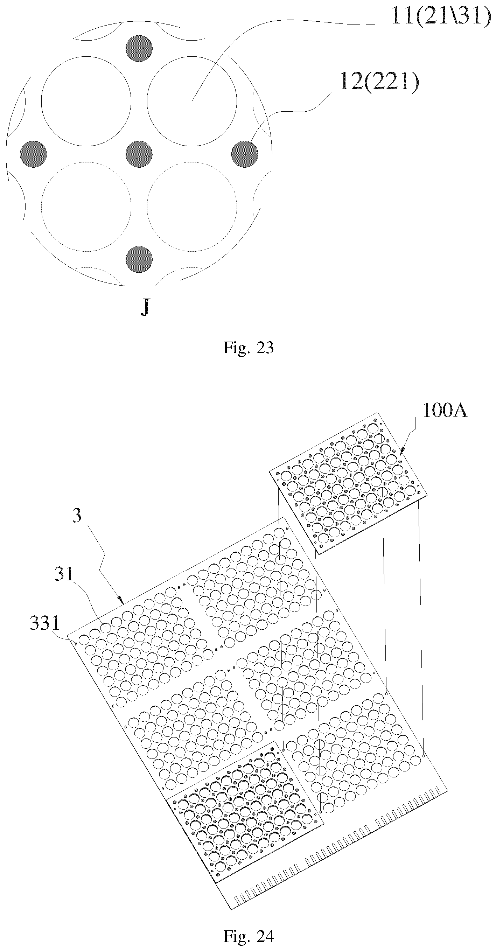

Fig. 23 is an enlarged view of area J in Fig. 21.
Fig. 24 is a 3D disassembled diagram of a second transparent display screen provided in a specific embodiment of the present application.

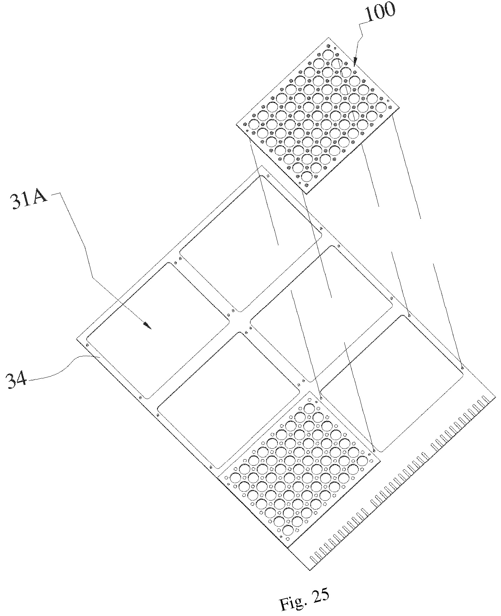

Fig. 25 is a 3D disassembled diagram of a third transparent display screen provided in a specific embodiment of the present application.

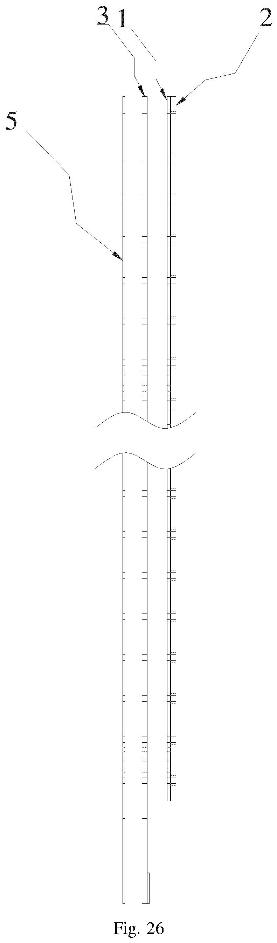

Fig. 26 is a cross-sectional diagram of a further improved fourth transparent display screen provided in a specific embodiment of the present application.

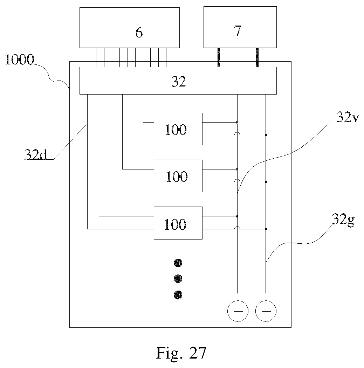

Fig. 27 is a schematic diagram of power supply and signal control for the transparent display screen provided in a specific embodiment of the present application.

Reference signs in the Background are as follows:
100'. Transparent display screen; 1'. Circuit substrate; 2'. LED lamp bead; 3'. Transparent glass; 10'. Through hole;

Reference signs in the specific embodiments are as follows:
100. Transparent light-emitting module; 1000. Transparent display screen; 101. Peripheral non-light-transmitting area;
1. Light-transmitting substrate; 2. Light-transmitting cover plate; 3. Light-transmitting motherboard; 4. Transparent carrier; 5. Hollow reinforcing sheet . 6. Signal module; 7. Power module;
11. First light-transmitting hole; 12. Light-emitting pixel; 13. Electrical connection part; 21. Second light-transmitting hole; 22. Pixel through hole; 221. Light-transmitting adhesive; 11a. Central light-transmitting hole; 11b. Adjacent-edge light-transmitting hole; 11c. Adjacent-corner light-transmitting hole; 121. Driver chip; 12R. Red light-emitting die; 12G. Green light-emitting die; 12B. Blue light-emitting die; 31. Third light-transmitting hole; 32. External connection port area; 32v. Positive power line; 32g. Negative power line; 32d. Signal line; 321. Connection PIN; 33. Module connection part; 331. Electrical connector; 34. Non-light-transmitting frame; 31A. Hollow light-transmitting area.

### Detailed description of disclosed embodiments

To make the technical problems, technical solutions and beneficial effects of the present application more clear, the application will be further explained in detail below with reference to the drawings and embodiments. It should be understood that the specific embodiments described here are only used to illustrate the application, rather than to limit the application.

In the description of the present application, it is to be understood that the terms "longitudinal", "radial", "length", "width", "thickness", "upper", "lower", "front", "rear", "left", "right", "vertical", "horizontal", "top", "bottom", "inner", "outer", and the like indicate an orientation or positional relationship based on that shown in the drawings. They are only for convenience of description and simplicity of description only, not intended to indicate or imply that the indicated devices or elements must have a particular orientation, be constructed and operated in a particular orientation, and are therefore not to be construed as limiting the present application. In the description of the present application, unless otherwise stated, "multiple" means two or more.

In the description of this application, it should be noted that unless otherwise specified and limited, the terms "install," "connect," and "link" should be understood broadly. For example, they may be fixed connections, detachable connections, or integral connections; they may be mechanical connections or electrical connections; they may be direct connections or indirect connections through an intermediate medium, or internal communication of two elements. For those skilled in the art, the specific meanings of the above terms in this application can be understood according to specific situations.

### Embodiment 1

As shown in Figs. 7-9, this embodiment provides a transparent light-emitting module 100, which includes a light-transmitting substrate 1 and a light-transmitting cover plate 2. The light-transmitting holes are correspondingly arranged in arrays on both light-transmitting substrate 1 and the light-transmitting cover plate 2; areas excluding the light-transmitting holes form a non-light-transmitting area. Generally, the larger the area of the light-transmitting region compared to the non-light-transmitting area, the higher the transparency and better the light transmittance performance of the transparent light-emitting module 100. In this application, the light-transmitting substrate 1 is generally made of a non-transparent material, typically a printed circuit board (PCB), composed of at least two circuit layers. The circuit layers on the substrate form the driver circuit, which provides power and signals to each light-emitting pixel 12.

For distinction, the light-transmitting holes on the light-transmitting substrate 1 are referred to as the first light-transmitting hole 11, and the light-transmitting holes formed on the light-transmitting cover plate 2 are referred to as the second light-transmitting hole 21. The shape of the light-transmitting holes may be circular through-holes as shown in the figure, or they may be triangular, quadrilateral, or any other polygonal shape, as well as other regular or irregular forms, with a preference for circular through-holes.

The light-transmitting substrate 1 is provided with a driver circuit and pixel pads, with the pixel pads arranged in an array in the non-light-transmitting area outside the first light-transmitting hole 11. A plurality of light-emitting pixels 12 are mounted on the pixel pads and connected to the driver circuit via the pixel pads. The light-emitting pixel 12 includes a driver chip 121 and a light-emitting die. The light-emitting die in this application is known to the public and typically includes a red light-emitting die 12R, a green light-emitting die 12G, and a blue light-emitting die 12B. Each light-emitting pixel 12 in this application includes one driver chip 121; therefore, the driver chip 121 is not separately set as in conventional LED display devices. Instead, the driver chip 121 is integrated into each light-emitting pixel 12. In this example, the light-emitting pixel 12 may be an LED lamp bead after integrating the light cup. As a preferred solution, the light-emitting pixel 12 in this embodiment differs from the conventional LED lamp bead, which typically includes a lamp cup. In this embodiment, the lamp cup is unnecessary, and the driver chip 121 and the light-emitting die are directly mounted as bare LEDs without the lamp cup on the light-transmitting substrate 1. As shown in Fig. 10, the red light-emitting die 12R, blue light-emitting die 12B, and green light-emitting die 12G may be independently mounted outside the driver chip 121, or, as shown in Fig. 11, the red light-emitting die 12R, green light-emitting die 12G, and blue light-emitting die 12B may be mounted directly on the driver chip 121. The light-emitting die and the driver chip 121 may be connected through bonding wires (or solid crystal wires or gold-soldering wires).

On the non-light-transmitting area of the light-transmitting cover plate 2, outside the second light-transmitting hole 21, pixel through holes 22 are arranged in an array. These pixel through holes 22 correspond to the pixel pads, allowing the light-emitting pixel 12 to be located within the pixel through hole 22. The number of pixel through holes 22 is consistent with the number of light-emitting pixels 12 since each pixel through hole 22 is designed to accommodate a corresponding light-emitting pixel 12.

In this embodiment, as a preferred solution, as shown in Fig. 8, a light-transmitting adhesive 221 is filled into the pixel through hole 22 to transparently encapsulate the light-emitting pixel 12 within the pixel through hole 22. The light-emitting pixel 12 and the light-transmitting adhesive 221 form an LED package accommodated in the pixel through hole 22. The encapsulation with light-transmitting adhesive 221 further enhances the protection, improving the sealing of the resulting transparent light-emitting module 100, providing better water and moisture resistance, and offering additional protection to the light-emitting pixel 12 in the pixel through hole 22.

The light-transmitting substrate 1 is provided with an electrical connection part 13 for inputting power and signals from outside the transparent light-emitting module 100. In this embodiment, the transparent light-emitting module 100 can be used directly as the display panel of a screen, for example, by directly connecting to an external power module and signal module to enable power and signal input. It can also be used as a small unit, further mounted on a larger-sized motherboard to form a larger transparent display screen 1000 after assembly. Further embodiments of the present application will be described later, and no additional details will be provided in this embodiment.

In this embodiment, the electrical connection part 13 includes a plurality of power connection structures and signal connection structures arranged on the non-light-transmitting area of the light-transmitting substrate 1.

In the present application, the power connection structure is a first power connection hole, and the signal connection structure is a first signal connection hole. The power connection structure and signal connection structure of the electrical connection part 13 are arranged either concentrically or dispersedly at any position on the non-light-transmitting area of the light-transmitting substrate 1. Preferably, the power connection structure and signal connection structure of the electrical connection part 13 are arranged concentrically or dispersedly at the corner or edge of the light-transmitting substrate 1.

As shown in Figs. 7-9, further, at one or more first light-transmitting holes 11 on the light-transmitting substrate 1, a non-light-transmitting structure is formed as the electrical connection part 13. In this embodiment, one of the first light-transmitting holes 11 is made into a non-light-transmitting structure, allowing the power connection structure and signal connection structure to be concentrated in one area, achieving simpler electrical connections while causing only minimal loss of light transmissibility.

As shown in Figs. 7 to 9 of this embodiment, the light-transmitting holes on the light-transmitting substrate 1 and the light-transmitting cover plate 2 include, as an example, a first light-transmitting hole, which includes a central light-transmitting hole 11a of a full-hole shape in the center area, an adjacent-edge light-transmitting hole 11b of a semi-hole shape at edge positions, and an adjacent-corner light-transmitting hole 11c of a quarter-hole shape at corner positions. The adjacent-edge light-transmitting holes 11b of two adjacent light-emitting modules can combine to form a full-hole shape, and the four adjacent-corner light-transmitting holes 11c of the light-emitting modules can combine to form a full-hole shape.

The size of the light-transmitting holes can be optimized and designed according to actual needs during the production process, balancing transparency and ensuring the display performance of the product. For those skilled in the art, with the approach already introduced in this embodiment, no creative effort is required to achieve it.

The light-transmitting cover plate 2 is preferably made of plastic material by injection molding, or any other material formed into a plate-like structure that can be bonded to the light-transmitting substrate 1. It can also be a printed circuit board, with a printed circuit board that does not contain internal circuits being preferably used as the light-transmitting cover plate. Alternatively, it is preferable that both the light-transmitting cover plate 2 and the light-transmitting substrate 1 are made of printed circuit boards, forming a composite circuit board structure, with the light-transmitting cover plate 2 and the light-transmitting substrate 1 being laminated or bonded together. The material of the light-transmitting cover plate may can be a non-transparent structure overall, with light transmission only at the second light-transmitting hole 21, or the light-transmitting cover plate 2 may be made of a transparent material throughout.

In this embodiment, the light-emitting pixel 12 is arranged in the pixel through hole 22 formed by the light-transmitting cover plate 2. This arrangement reduces the risk of the light-emitting pixel 12 being damaged by collisions. Additionally, there are no exposed solder joints on the light-emitting pixel 12, making it easier to achieve waterproof and moisture-proof properties. The light-emitting display surface of the transparent light-emitting module 100 is the light-transmitting cover plate 2, which is flat, and the display surface can be directly attached to flat products like glass (see Figs. 17 and 18). Meanwhile, as shown in Fig. 23, under the same spacing conditions, the area occupied by the light-emitting pixel 12 in this embodiment is smaller compared to the prior art, thereby improving display density and increasing the resolution of the transparent display screen 1000.

### Embodiment 2:

In this embodiment, the other structures are the same as those in Embodiment 1, but the arrangement of the light-transmitting holes on the light-transmitting substrate 1 and the light-transmitting cover plate 2 is slightly different. As shown in Fig. 12, the light-transmitting holes on the light-transmitting substrate 1 and the light-transmitting cover plate 2 are all central light-transmitting holes 11a in a full-hole shape, with no light-transmitting holes provided along the periphery, thereby forming a peripheral non-light-transmitting area 101. At this point, since the peripheral non-light-transmitting area 101 has sufficient space for accommodating the electrical connection part 13, the more preferred solution in this example is to disperse the first power connection hole and the first signal connection hole in the electrical connection part 13 in the peripheral non-light-transmitting area 101. Alternatively, they may be integrated on one side or arranged at a corner.

In this embodiment, the peripheral edges of the light-transmitting cover plate 2 and the light-transmitting substrate 1 are configured as non-perforated areas, which is beneficial for the flatness and stability of the transparent light-emitting module 100. The peripheral edges provide sufficient space for wiring, facilitating manufacturing and enabling more reasonable and reliable internal wiring.

### Embodiment 3

This embodiment provides a transparent display screen 1000, as shown in Figs. 13 to 22, including a light-transmitting motherboard 3 and one or more transparent light-emitting modules 100 mounted on the light-transmitting motherboard 3. The light-transmitting motherboard 3 includes a light-transmitting area and a non-light-transmitting area, where the non-light-transmitting area is provided with a transmission circuit for supplying power and signals to the transparent light-emitting modules 100. Each transparent light-emitting module 100 is electrically connected to the light-transmitting motherboard 3; and
the transparent light-emitting module 100 includes a light-transmitting substrate 1 and a light-transmitting cover plate 2. The light-transmitting substrate 1 and the light-transmitting cover plate 2 are each provided with an array of mutually corresponding light-transmitting holes, and the projections of the light-transmitting holes are located in the light-transmitting area of the light-transmitting motherboard 3. Areas outside the light-transmitting holes form the non-light-transmitting area. The design of the light-transmitting area and the non-light-transmitting area on the light-transmitting motherboard 3 in this example is not necessarily in a one-to-one mapping relationship with the light-transmitting holes and the non-light-transmitting area of the transparent light-emitting module 100. Rather, it is sufficient that the projections of the light-transmitting holes of the transparent light-emitting module 100 fall within the light-transmitting area of the light-transmitting motherboard 3. Since the light-transmitting motherboard 3 does not need to have the light-emitting pixels 12 arranged in an array, it only requires a small non-light-transmitting area to accommodate the transmission circuit, and thus, the light-transmitting area of the light-transmitting motherboard 3 can be of any suitable size. For example, as one implementation, as shown in Fig. 13, the light-transmitting area of the light-transmitting motherboard 3 includes third light-transmitting holes 31 arranged in an array thereon. Areas outside the third light-transmitting holes 31 form the non-light-transmitting area; the third light-transmitting holes 31 are arranged in a one-to-one correspondence with the first light-transmitting holes 11 and the second light-transmitting holes 21.

The light-transmitting holes formed on the light-transmitting substrate 1 are first light-transmitting holes 11, and second light-transmitting holes 21 are formed on the light-transmitting cover plate 2;
the light-transmitting substrate 1 is provided with a driver circuit and pixel pads, the pixel pads being arranged in an array on the non-light-transmitting area outside the first light-transmitting holes 11. A plurality of light-emitting pixels 12 are mounted on the pixel pads and connected to the driver circuit via the pixel pads. Each light-emitting pixel 12 includes a driver chip 121 and a light-emitting die; and
pixel through holes 22 are arranged in an array on the non-light-transmitting area outside the second light-transmitting holes 21 of the light-transmitting cover plate 2, and the pixel through holes 22 correspond to the pixel pads, such that the light-emitting pixels 12 are located within the pixel through holes 22.

Preferably, the light-transmitting substrate 1 in this embodiment is the same as the light-transmitting substrate 1 described in Embodiment 1, and the content described in Embodiment 1 may be reproduced in the present embodiment. To avoid repetition, the parts already described in Embodiment 1 are not described again here.

In this application, the transparent light-emitting module 100 and the light-transmitting motherboard 3 are arranged in a separated manner. Since the transparent light-emitting module 100 generally has a relatively small size, typically within the range of 80-160 mm in length and width, it can be manufactured more conveniently, with higher efficiency and more stable quality within the processing stroke range of precision machining equipment. The light-transmitting motherboard 3, on the other hand, can be fabricated in a larger size. However, since its internal circuit structure is relatively simple, stable quality can still be readily ensured.

In this embodiment, an electrical connection part 13 is provided on the light-transmitting substrate 1. As shown in Figs. 13, 14, and 20, a module connection part 33 is provided on the light-transmitting motherboard 3, and the module connection part 33 on the light-transmitting motherboard 3 is electrically connected to the electrical connection part 13 on the light-transmitting substrate 1, so as to input power and signals from the light-transmitting motherboard 3 to the transparent light-emitting module 100.

In this embodiment, the power connection structure on the light-transmitting substrate 1 is a first power connection hole, and the signal connection structure is a first signal connection hole. The power connection structure on the light-transmitting motherboard 3 is a second power connection hole, and the signal connection structure is a second signal connection hole. The first power connection hole is connected to the second power connection hole, and the first signal connection hole is connected to the second signal connection hole, via electrical connectors 331. The electrical connector 331 in this embodiment is a metal pin-shaped or metal column-shaped connecting member, which is soldered for electrical connection. Alternatively, the power and signal connection structures on the light-transmitting substrate 1 and the light-transmitting motherboard 3 may adopt other electrical connection methods, as long as electrical connection between the light-transmitting substrate 1 and the light-transmitting motherboard 3 can be achieved.

In this embodiment, at least one of the first light-transmitting holes 11 in the light-transmitting substrate 1 is configured as a non-light-transmitting structure to serve as the electrical connection part 13. Similarly, at least one of the third light-transmitting holes 31 in the light-transmitting motherboard 3 is configured as a non-light-transmitting structure to serve as the module connection part 33. The electrical connection part 13 of the light-transmitting substrate 1 is connected to the module connection part 33 of the light-transmitting motherboard 3.

The light-transmitting substrate 1 and light-transmitting motherboard 3 are both printed circuit boards, each conposed of at least two circuit layers. The circuit layers on the light-transmitting motherboard 3 form a transmission circuit that provides power and signals to the light-transmitting substrate 1. The circuit layers on the light-transmitting substrate 1 form a driver circuit that supplies power and signals to the light-emitting pixels 12. That is, the transmission circuit on the light-transmitting motherboard 3 is electrically connected to the electrical connection part 13 on the light-transmitting substrate 1 through the module connection part 33, transmitting power and signals from the transmission circuit to the driver circuit on the light-transmitting substrate 1. The driver circuit then powers and provides signals to each light-emitting pixel 12.

Similarly, as shown in Figs. 13-16, the light-transmitting holes on the light-transmitting substrate 1 and the light-transmitting cover plate 2, taking the first light-transmitting hole as an example, include a central light-transmitting hole 11a of a full-hole shape set in the center area, an adjacent-edge light-transmitting hole 11b of a semi-hole shape at the edge positions, and an adjacent-corner light-transmitting hole 11c of a quarter-hole shape at the corner positions; the adjacent-edge light-transmitting holes 11b of two adjacent light-emitting modules can combine to form a full-hole shape, and the adjacent-corner light-transmitting holes 11c of four light-emitting modules can combine to form a full-hole shape.

As shown in Figs. 13, 15, 19, and 20, the light-transmitting motherboard 3 is also provided with an external connection port area 32 connected to the power module and signal module; the external connection port area 32 is equipped with connection PIN 321 that connects to the power module 7 and signal module 6. As shown in Fig. 27, the connection PIN 321 in the external connection port area 32 is internally connected to the transmission circuit on the light-transmitting motherboard 3, and through this connection PIN 321, it connects to the external power module 7 and signal module 6. The transmission circuit includes power transmission lines and signal transmission lines. The power transmission lines include a positive power line 32v and a negative power line 32g, both of which are connected to each transparent light-emitting module 100 to provide power to each transparent light-emitting module 100. The signal transmission lines include several signal lines 32d connected to each transparent light-emitting module 100, and through these signal lines 32d, signals are provided to each transparent light-emitting module 100.

As a further preferred approach, the transparent light-emitting module 100 is adhesively bonded to the light-transmitting motherboard 3. In this way, while achieving electrical connection between the light-transmitting motherboard 3 and the transparent light-emitting module 100, the mechanical strength of both the light-transmitting motherboard 3 and the transparent light-emitting module 100 can also be enhanced.

The transparent display screen 1000 provided in this embodiment allows the light-emitting pixel 12 to be arranged within the pixel through hole 22 formed by the light-transmitting cover plate 2, making it less prone to collisions or damage. This configuration ensures that the light-emitting pixel 12 does not have exposed solder joints, which makes it easy to achieve waterproof and moisture-proof capabilities. The light-emitting display surface of this transparent light-emitting module 100 is the light-transmitting cover plate 2, which is flat, and this display surface can be directly attached to flat products like glass (see Figs. 17 and 18). Additionally, as shown in Fig. 23, under the same spacing conditions, compared to the prior art, the area occupied by the light-emitting pixel 12 in this application is smaller, thus improving display density and increasing the resolution of the transparent display screen 1000.

At the same time, because each light-emitting pixel 12 is equipped with a driver chip that directly drives the light-emitting chip, the internal circuitry of the transparent light-emitting module 100 becomes very simple. In general, aside from the power lines, only one to two signal lines are needed to serially connect all the light-emitting pixels 12 within the transparent light-emitting module 100. When N transparent light-emitting modules 100 are mounted on the light-transmitting motherboard 3, the signal lines required on the light-transmitting motherboard 3 can be as few as N lines, and at most 2N lines. Therefore, neither the transparent light-emitting module 100 nor the light-transmitting motherboard 3 requires the mounting of additional electronic components, making the entire product neat and tidy.

### Embodiment 4

As shown in Fig. 25, most of the content in this embodiment is the same as in Embodiment 3, with the only difference being that the light-transmitting holes on both the light-transmitting substrate 1 and the light-transmitting cover plate 2 are full-hole shaped central light-transmitting holes 11a, and no light-transmitting holes are provided along their peripheral edges, forming a surrounding peripheral non-light-transmitting area 101.

In this embodiment, the edges around the light-transmitting cover plate 2 and light-transmitting substrate 1 are set as non-perforated areas. This design helps improve the flatness and stability of the transparent light-emitting module 100, provides enough space for wiring around the edges, facilitates processing, and ensures more reasonable and reliable internal wiring.

### Embodiment 5

This embodiment is mostly the same as Embodiment 4 described above. As shown in Fig. 25, the only difference lies in the configuration of the light-transmitting area on the light-transmitting motherboard 3. Assuming that the number of transparent light-emitting modules 100 is N, the light-transmitting motherboard 3 includes a non-light-transmitting frame 34 and N hollow light-transmitting areas 31A formed in the non-light-transmitting frame 34. Each hollow light-transmitting area 31A is correspondingly provided with one transparent light-emitting module 100.

The light-transmitting motherboard 3 can be hollowed out in this manner: the welding between the light-transmitting motherboard 3 and the transparent light-emitting module 100 is achieved through the electrical connection parts distributed at the four corners. On the one hand, this provides power and signal to the transparent light-emitting module 100, and on the other hand, it also achieves the mechanical connection of the transparent light-emitting module 100.

### Embodiment 6

This embodiment references the content of Embodiments 3 to 5, and as a preferred solution, as shown in Fig. 26, it also includes a hollow reinforcing sheet. As a further preferred solution, the hollow reinforcing sheet is arranged on the back side of the light-transmitting motherboard 3. The hollow reinforcing sheet has a hollow area, which corresponds to the projection covering the light-transmitting area of the light-transmitting motherboard 3 and the transparent light-emitting module 100. The material of the hollow reinforcing sheet can be, for example, stainless steel or other metals with similar or higher strength. The hollow reinforcing sheet is affixed to the side of the light-transmitting motherboard 3 that is away from the transparent light-emitting module 100, and the pattern of the hollow area of the hollow reinforcing sheet is preferably the same as the light-transmitting area of the light-transmitting motherboard 3. In this way, the strength of the finished transparent display screen 1000 can be further enhanced.

The above are merely the preferred embodiments of this application, and are not intended to limit the application. Any modification, equivalent substitution and improvement made within the spirit and principle of this application shall be included in the protection scope of this application.

## Claims

1. A transparent light-emitting module, comprising a light-transmitting substrate and a light-transmitting cover plate; wherein:
light-transmitting holes are correspondingly arranged in arrays on both the light-transmitting substrate and the light-transmitting cover plate, allowing the transparent light-emitting module to exhibit a transparent effect; areas excluding the light-transmitting holes form a non-light-transmitting area;
the light-transmitting hole on the light-transmitting substrate is a first light-transmitting hole, and the light-transmitting hole on the light-transmitting cover plate is a second light-transmitting hole;
the light-transmitting substrate is provided with a driver circuit and pixel pads, and the pixel pads are arranged in an array within the non-light-transmitting area excluding the first light-transmitting holes; a plurality of light-emitting pixels are mounted on the pixel pads and are connected to the driver circuit through the pixel pads; each light-emitting pixel comprises a driver chip and a light-emitting die; and
pixel through holes are arranged in an array within the non-light-transmitting area excluding the second light-transmitting holes on the light-transmitting cover plate; and the pixel through holes correspond to the pixel pads, allowing the light-emitting pixels to be located within the pixel through holes.

2. The transparent light-emitting module of claim 1, wherein:
the pixel through hole is filled with a light-transmitting adhesive to transparently encapsulate the light-emitting pixel inside the pixel through hole; the light-emitting pixel and the light-transmitting adhesive together form an LED package accommodated in the pixel through hole.

3. The transparent light-emitting module of claim 1, wherein:
the light-transmitting substrate is provided with an electrical connection part configured to input power and signals from outside the transparent light-emitting module; and
the electrical connection part comprises a plurality of power connection structures and signal connection structures arranged on the non-light-transmitting area of the light-transmitting substrate.

4. The transparent light-emitting module of claim 3, wherein:
the power connection structures are first power connection holes, and the signal connection structures are first signal connection holes.

5. The transparent light-emitting module of claim 3, wherein:
the power connection structures and signal connection structures of the electrical connection part are arranged either concentrically or dispersedly at a corner or an edge of the light-transmitting substrate.

6. The transparent light-emitting module of claim 2, wherein:
a non-light-transmitting structure is arranged as the electrical connection part at one or more of the first light-transmitting holes on the light-transmitting substrate.

7. The transparent light-emitting module of claim 1, wherein:
the light-transmitting substrate is a printed circuit board, composed of at least two circuit layers, with the circuit layers forming the driver circuit, and the driver circuit provides power and signals to each of the light-emitting pixels.

8. The transparent light-emitting module of claim 1, wherein:
the light-transmitting holes on the light-transmitting substrate and the light-transmitting cover plate comprise: central light-transmitting holes of a full-hole shape in center area, adjacent-edge light-transmitting holes of a semi-hole shape at edge positions, and adjacent-corner light-transmitting holes of a quarter-hole shape at corner positions; the adjacent-edge light-transmitting holes of two adjacent light-emitting modules are able to combine to form a full-hole shape; and the adjacent-corner light-transmitting holes of four light-emitting modules are able to combine to form a full-hole shape.

9. The transparent light-emitting module of claim 1, wherein:
the light-transmitting holes on both the light-transmitting substrate and the light-transmitting cover plate are central light-transmitting holes of a full-hole shape, and no light-transmitting holes are arranged around their peripheral edges, forming a peripheral non-light-transmitting area.

10. The transparent light-emitting module of claim 1, wherein:
the light-transmitting substrate and the light-transmitting cover plate are laminated or bonded together.

11. A transparent display screen, comprising a light-transmitting motherboard and one or more transparent light-emitting modules mounted on the light-transmitting motherboard; wherein:
the light-transmitting motherboard is provided with a light-transmitting area and a non-light-transmitting area; the non-light-transmitting area is provided with a transmission circuit configured to supply power and signals to the transparent light-emitting module; each transparent light-emitting module is electrically connected to the light-transmitting motherboard;
each transparent light-emitting module comprises a light-transmitting substrate and a light-transmitting cover plate; light-transmitting holes are correspondingly arranged in arrays on both the light-transmitting substrate and the light-transmitting cover plate, and projections of the light-transmitting holes fall within the light-transmitting area of the light-transmitting motherboard; and areas excluding the light-transmitting holes form a non-light-transmitting area;
the light-transmitting hole on the light-transmitting substrate is a first light-transmitting hole, and the light-transmitting hole on the light-transmitting cover plate is a second light-transmitting hole;
the light-transmitting substrate is provided with a driver circuit and pixel pads, and the pixel pads are arranged in an array within the non-light-transmitting area excluding the first light-transmitting holes; a plurality of light-emitting pixels are mounted on the pixel pads and are connected to the driver circuit through the pixel pads; each light-emitting pixel comprises a driver chip and a light-emitting die; and
pixel through holes are arranged in an array within the non-light-transmitting area excluding the second light-transmitting holes on the light-transmitting cover plate; and the pixel through holes correspond to the pixel pads, allowing the light-emitting pixels to be located within the pixel through holes.

12. The transparent display screen of claim 11, wherein:
the pixel through hole is filled with a light-transmitting adhesive to transparently encapsulate the light-emitting pixel inside the pixel through hole; the light-emitting pixel and the light-transmitting adhesive together form an LED package accommodated in the pixel through hole.

13. The transparent display screen of claim 11, wherein:
the light-transmitting substrate is provided with an electrical connection part; the light-transmitting motherboard is provided with a module connection part, and the module connection part on the light-transmitting motherboard is electrically connected to the electrical connection part on the light-transmitting substrate, allowing power and signals to be supplied from the light-transmitting motherboard to the transparent light-emitting module.

14. The transparent display screen of claim 13, wherein:
the electrical connection part on the light-transmitting substrate and the module connection part on the light-transmitting motherboard are correspondingly provided with a plurality of power connection structures and signal connection structures.

15. The transparent display screen of claim 14, wherein:
the power connection structure on the light-transmitting substrate is a first power connection hole, and the signal connection structure is a first signal connection hole; the power connection structure on the light-transmitting motherboard is a second power connection hole, and the signal connection structure is a second signal connection hole; the first power connection hole is connected to the second power connection hole, and the first signal connection hole is connected to the second signal connection hole, via electrical connectors.

16. The transparent display screen of claim 13, wherein:
the power connection structures and signal connection structures of the electrical connection part are arranged either concentrically or dispersedly at a corner or an edge of the light-transmitting substrate.

17. The transparent display screen of claim 13, wherein:
a non-light-transmitting structure is arranged as the electrical connection part at one or more of the first light-transmitting holes on the light-transmitting substrate; a non-light-transmitting structure is also arranged as the module connection part in one or more third light-transmitting holes in the light-transmitting motherboard; and the electrical connection part on the light-transmitting substrate is correspondingly connected to the module connection part on the light-transmitting motherboard.

18. The transparent display screen of claim 11, wherein:
the light-transmitting substrate and the light-transmitting motherboard are both printed circuit boards, each composed of at least two circuit layers; the circuit layers on the light-transmitting motherboard form the transmission circuit configured to supply power and signals to the light-transmitting substrate; the circuit layers on the light-transmitting substrate form a driver circuit configured to supply power and signals to each of the light-emitting pixels.

19. The transparent display screen according to claim 11, wherein:
the light-transmitting area of the light-transmitting motherboard comprises third light-transmitting holes arranged in an array thereon; areas excluding the third light-transmitting holes forms the non-light-transmitting area; and the third light-transmitting holes are arranged in a one-to-one correspondence with the first light-transmitting holes and the second light-transmitting holes.

20. The transparent display screen of claim 19, wherein:
the light-transmitting holes on the light-transmitting substrate and the light-transmitting cover plate comprise: central light-transmitting holes of a full-hole shape in center area, adjacent-edge light-transmitting holes of a semi-hole shape at edge positions, and adjacent-corner light-transmitting holes of a quarter-hole shape at corner positions; the adjacent-edge light-transmitting holes of two adjacent light-emitting modules are able to combine to form a full-hole shape; and the adjacent-corner light-transmitting holes of four light-emitting modules are able to combine to form a full-hole shape.

21. The transparent display screen of claim 19, wherein:
the light-transmitting holes on both the light-transmitting substrate and the light-transmitting cover plate comprise central light-transmitting holes of a full-hole shape, with no light-transmitting holes arranged around their peripheral edges, forming a peripheral non-light-transmitting area.

22. The transparent display screen of claim 21, wherein:
the number of transparent light-emitting modules is N, and the light-transmitting motherboard comprises a non-light-transmitting frame and N hollow light-transmitting areas formed in the non-light-transmitting frame, and each hollow light-transmitting area is correspondingly provided with one of the transparent light-emitting modules.

23. The transparent display screen of claim 11, further comprising a hollow reinforcing sheet, wherein:
the hollow reinforcing sheet is arranged on a back surface of the light-transmitting motherboard; the hollow reinforcing sheet has a hollow area formed thereon, and a projection corresponding to the hollow area covers the the light-transmitting area of the light-transmitting motherboard and the transparent light-emitting module.

24. The transparent display screen of claim 11, wherein the light-transmitting motherboard is further provided with an external connection port area connected to a power module and a signal module; and the external connection port area is provided with a connection PIN connected to the power module and the signal module.

25. The transparent display screen of claim 11, wherein the transparent light-emitting module is adhesively connected to the light-transmitting motherboard.
